# EUROPEAN PATENT APPLICATION

(11) **EP 2 503 590 A1**
(43) Date of publication of application: **26.09.2012**
(21) Application number: 10831327.1
(22) Date of filing: 17.11.2010
(51) Int. Cl.: H01L 21/027, G03F 7/20

(54) **OPTICAL CHARACTERISTIC MEASUREMENT METHOD, EXPOSURE METHOD AND DEVICE MANUFACTURING METHOD**

(30) Priority: 17.11.2009 JP 2009261636
(71) Applicant: Nikon Corporation, Tokyo 100-8331 (JP)
(72) Inventor: KOSUGI, Junichi, Tokyo 100-8331 (JP); HIRUKAWA, Shigeru, Tokyo 100-8331 (JP); KONDO, Naoto, Tokyo 100-8331 (JP)
(74) Representative: HOFFMANN EITLE
(86) International application number: PCT/JP2010/006729
(87) International publication number: WO 2011/061928

(57) **Abstract**

An image of a pattern used for measurement formed on a reticle for testing is transferred onto a wafer for testing via a projection optical system, while gradually changing a position of the wafer in an optical axis direction of the projection optical system. The image (MP"ₙ) of the pattern used for measurement which has been transferred is detected, and an amount corresponding to an expanse of the image of the pattern in a measurement direction is obtained. In this case, four images (LS"_{Vn}, LS"_{Hn}, LS"_{Rn}, LS"_{Ln}) included in the image (MP"ₙ) of the pattern used for measurement are detected in detection areas (DVⱼ, DHⱼ, DRⱼ, DLⱼ), respectively, or in other words, remaining sections except for both ends in a non-measurement direction are detected and an area of the remaining sections is to be obtained as the corresponding amount. Optical properties of the projection optical system are to be obtained, based on the area which has been obtained. Because the area which has been obtained does not have sensitivity to the non-measurement direction, the optical properties of the projection optical system in the measurement direction can be precisely obtained.

## Description

### TECHNICAL FIELD

The present invention relates to optical properties measurement methods, exposure methods, and device manufacturing methods, and more particularly to an optical properties measurement method in which optical properties of an optical system that generates a pattern image on a predetermined plane are measured, an exposure method in which exposure is performed taking into consideration optical properties measured by the optical properties measurement method, and a device manufacturing method using the exposure method.

### BACKGROUND ART

Semiconductor devices (integrated circuits) are becoming highly integrated year by year, and with this, a higher resolution is becoming required in a projection exposure apparatus such as a stepper, which is a manufacturing apparatus of semiconductor devices and the like. Further, it is also important to improve the overlay accuracy with respect to a pattern which is already formed on an object subject to exposure from the next layer onward. As a premise for this, it becomes necessary to measure and evaluate the optical properties (including an image-forming characteristic) of the projection optical system accurately, and to improve (including the case of improvement by adjustment) the optical properties of the projection optical system based on the evaluation results.

In order to obtain the optical properties of the projection optical system, such as for example, astigmatism, as a premise, the optimum focus position (best focus position) with respect to two measurement directions which are orthogonal to each other has to be precisely measured at an evaluation point (measurement point) within an image plane.

As an example of a measurement method of the best focus position of the projection optical system, a method disclosed in, for example, PTL 1 is known. In this method, exposure is performed using a reticle on which a predetermined pattern (for example, a dense line pattern (line-and-space pattern) and the like) is formed as a test pattern, and the test pattern is transferred onto a test wafer at a plurality of positions in an optical axis direction of the projection optical system. A resist image (an image of the transferred pattern) which is obtained by developing the test wafer is picked up, for example, by an image-forming alignment sensor and the like equipped in the exposure apparatus, and the best focus position is obtained, based on a relation between a contrast value (for example, dispersion of the brightness value of a pixel, and the like) of the image of the test pattern obtained from the imaging data and a position of the wafer in the optical axis direction of the projection optical system. Therefore, this method is also referred to as a contrast focus method.

However, it has recently become clear that it is difficult to obtain astigmatism of the projection optical system equipped in the current exposure apparatus, precisely at the required level, using the contrast focus method. It is conceivable that this is caused by sensitivity with respect to a non-measurement direction orthogonal to the measurement direction being generated when the length of the pattern image in the non-measurement direction becomes shorter along with defocus, in addition to sensitivity of the contrast value of the image with respect to the measurement direction (a sequence direction of the dense line) decreasing when the dense line pattern transferred onto the test wafer is not resolved under the exposure condition of the device manufacturing process due to finer patterns in recent years.

### CITATION LIST

### PATENT LITERATURE

[PTL 1] U.S. Patent Application Publication No. 2004/0179190

### DISCLOSURE OF THE INVENTION

### MEANS FOR SOLVING THE PROBLEM

According to a first aspect, there is provided a first optical properties measurement method to measure optical properties of an optical system which generates an image of a pattern placed on a first plane on a second plane, the method comprising: sequentially transferring a pattern used for measurement whose measurement direction is in a predetermined direction on an object via the optical system while changing a position of the object placed on a side of the second plane of the optical system in an optical axis direction of the optical system, and generating a plurality of divided areas including an image of the pattern used for measurement on the object; imaging a predetermined number of divided areas of the plurality of divided areas on the object, and extracting, of the image of the pattern used for measurement generated in each of the predetermined number of divided areas that have been imaged, imaging data related to at least a part of an image whose both ends in a non-measurement direction intersecting the measurement direction is excluded; and computing an evaluation amount in the measurement direction related to a brightness value of each pixel in each of the predetermined number of divided areas using the extracted imaging data, and obtaining the optical properties of the optical system based on the evaluation amount of each of the plurality of divided areas that has been computed.

With this method, while the position of the object placed on the side of the second plane of the optical system is changed in the optical axis direction of the optical system, a pattern used for measurement whose measurement direction is in a predetermined direction is sequentially transferred onto the obj ect via the optical system, and a plurality of divided areas including an image of the pattern used for measurement are generated on the object. Then, of the plurality of divided areas on the object, a predetermined number of divided areas are imaged, and of the image of the pattern used for measurement generated in each of the predetermined number of divided areas that have been imaged, imaging data related to at least a part of an image whose both ends in a non-measurement direction intersecting the measurement direction are excluded is extracted. Accordingly, the extracted imaging data hardly has sensitivity to the non-measurement direction at the time of the detection by defocus and the like.

And, an evaluation amount in the measurement direction related to a brightness value of each pixel in each of the predetermined number of divided areas is computed using the extracted imaging data, and the optical properties of the optical system are obtained based on the evaluation amount for each of the plurality of divided areas that has been computed. Accordingly, it becomes possible to obtain the optical properties of the optical system with good precision.

According to a second aspect, there is provided a second optical properties measurement method to measure optical properties of an optical system which generates an image of a pattern placed on a first plane on a second plane, the method comprising: sequentially transferring a pattern used for measurement whose measurement direction is in a predetermined direction on a plurality of areas on an object via the optical system and generating an image of the pattern used for measurement in each of the plurality of areas, while changing a position of the object placed on a side of the second plane of the optical system in an optical axis direction of the optical system; performing a trim exposure to each of the plurality of areas to remove both ends in the non-measurement direction of the image of the pattern used for measurement that is generated; imaging a predetermined number of divided areas among a plurality of divided areas on the object each including the image of the pattern used for measurement which has both sides removed in the non-measurement direction; and processing imaging data obtained by the imaging, and computing an evaluation amount in the measurement direction related to a brightness value of each pixel for each of the predetermined number of divided areas which have been imaged, and also obtaining optical properties of the optical system, based on the evaluation amount of each of the predetermined number of divided areas which has been computed.

With this method, by means of the trim exposure, a predetermined number of divided areas are imaged, from among a plurality of divided areas on the object each including the image of the pattern used for measurement which has both sides removed in the non-measurement direction. Therefore, the imaging data that has been obtained by this imaging hardly has sensitivity to the non-measurement direction at the time of the detection by defocus and the like.

And, the imaging data is processed, an evaluation amount in the measurement direction related to a brightness value of each pixel is computed for each of the predetermined number of divided areas which have been imaged, and the optical properties of the optical system are obtained based on the evaluation amount of each of the predetermined number of divided areas which has been computed. Accordingly, it becomes possible to obtain the optical properties of the optical system with good precision.

According to a third aspect, there is provided an exposure method, comprising: measuring optical properties of an optical system using one of the first and the second optical properties measurement methods of the present invention; and adjusting at least one of the optical properties of the optical system and a position of the object in an optical axis direction of the optical system and exposing an object by generating a predetermined pattern image on a predetermined plane via the optical system, taking into consideration measurement results of the optical properties.

With this method, the optical properties of the optical system are measured with high precision using the optical properties measurement method described above, and taking into consideration measurement results of the optical properties, a high-precision pattern image is generated in the exposure area of the optical system.

According to a fourth aspect, there is provided device manufacturing method, including: exposing an object by the exposure method of the present invention; and developing the object which has been exposed.

### BRIEF DESCRIPTION OF THE DRAWINGS

FIG. 1 is a view showing a schematic configuration of an exposure apparatus related to an embodiment.
FIG. 2 is a view showing an example of a reticle used to measure optical properties of a projection optical system.
FIG. 3 is a view showing an example of a configuration of a pattern MPₙ used for measurement.
FIG. 4 is a flow chart used to explain a measurement method of optical properties related to the embodiment.
FIG. 5 is a view used to explain an arrangement of divided areas.
FIG. 6 is a view showing a state in which evaluation point corresponding areas DB₁ to DB₅ are formed on a wafer W_{T}.
FIG. 7A is a view showing an example of a resist image formed in evaluation point corresponding area DB₁ formed on wafer W_{T} after wafer W_{T} has been developed, and FIG. 7B is a view showing a resist image formed in divided area DAᵢ within evaluation point corresponding area DBₙ.
FIG. 8 is a flow chart showing the details of step 426 (computation processing of the optical properties) in FIG. 4.
FIG. 9A is a view showing an example of imaging data related to a measurement direction of the resist image, and FIG. 9B is a view showing an example of imaging data related to a non-measurement direction.
FIG. 10 is a view used to explain a way to obtain the best focus position.
FIG. 11 is a view used to explain a modified example, showing a state where a transferred image of the pattern used for measurement is formed in a plurality of shot areas on wafer W_{T}.
FIG. 12 is a view showing an aperture stop plate used in Example 1.
FIG. 13 is a view showing four marks used in Example 1.
FIG. 14 is a view showing four marks used in a comparative example of Example 1.
FIG. 15 is a view showing an exposure amount dependence of the best focus computation value in the comparative example.
FIG. 16 is a view showing an exposure amount dependence of the best focus computation value in Example 1.
FIG. 17 is a view showing a mark used in Example 2.
FIG. 18A is a view used to explain a double exposure performed in Example 2, and FIG. 18B is a view showing a measurement mark which is obtained as a result of the double exposure.
FIG. 19 is a view showing an exposure amount dependence of best focus computation value according to an aerial image computation obtained as a result of Example 2.

### DESCRIPTION OF THE EMBODIMENTS

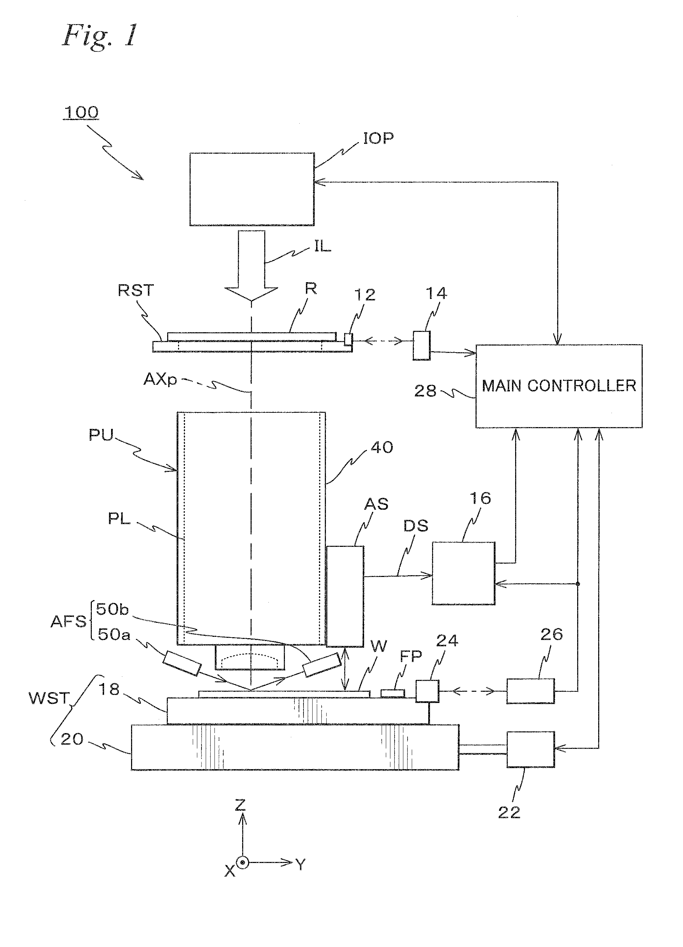

An embodiment of the present invention will be described below, with reference to FIGS. 1 to 10.

FIG. 1 shows a schematic configuration of an exposure apparatus 100 suitable for performing an optical properties measurement method and an exposure method related to the embodiment. Exposure apparatus 100 is a reduction projection exposure apparatus by the step-and-scan method (a so-called scanning stepper (also called a scanner)).

Exposure apparatus 100 is equipped with an illumination system IOP, a reticle stage RST holding a reticle R, a projection unit PU which projects an image of a pattern formed on reticle R on wafer W to which a photosensitive agent (a photoresist) is applied, a wafer stage WST which holds a wafer W, and moves in a two-dimensional plane (in an XY plane), a drive system 22 which drives wafer stage WST, a control system for these parts, and the like. The control system is mainly configured of a main controller 28 composed of a microcomputer (or a workstation) that performs overall control of the entire apparatus.

Illumination system IOP includes a light source consisting, for example, of an ArF excimer laser (output wavelength 193nm) (or a KrF excimer laser (output wavelength 248nm) and the like), an illumination system housing connected to the light source via a light-transmitting optical system, and an illumination optical system inside of the illumination system housing. The illumination optical system includes an illuminance uniformity optical system which includes an optical integrator and the like, a beam splitter, a relay lens, a variable ND filter, a reticle blind and the like (none of which are shown), as is disclosed in, for example, U.S. Patent Application Publication No.2003/0025890 and the like. The illumination optical system shapes a laser beam output from the light source, and illuminates a slit-shaped illumination area elongated in the X-axis direction (the orthogonal direction of the page surface of FIG. 1) on reticle R, with the shaped laser beam (hereinafter also referred to as illumination light) IL in a substantially uniform illuminance.

Reticle stage RST is placed below illumination system IOP in FIG. 1. Reticle R is mounted on reticle stage RST, and is held by suction via a vacuum chuck (not shown). Reticle stage RST can be finely driven within a horizontal plane (an XY plane) by a reticle stage drive system (not shown), and is also scanned within a predetermined stroke range in a scanning direction (in this case, to be a Y-axis direction which is the horizontal direction of the page surface of FIG. 1). The position of reticle stage RST is measured by a laser interferometer 14 via a movable mirror (or an end surface which is mirror processed) 12, and measurement values of laser interferometer 14 are supplied to main controller 28.

Projection unit PU is disposed below reticle stage RST in FIG. 1, and includes a barrel 40, and a projection optical system PL consisting of a plurality of optical elements which are held in a predetermined positional relation inside barrel 40. As projection optical system PL, a dioptric system is used, which is a both-side telecentric reduction system and is composed of a plurality of lens elements (drawing omitted) that share an optical axis AXp in the Z-axis direction. A specific plurality of lenses of the lens elements is controlled by an image-forming characteristic correction controller (not shown) based on instructions from main controller 28, and this allows optical properties (including the image-forming characteristic) of projection optical system PL such as, for example, magnification, distortion, comatic aberration and curvature of image plane to be adjusted.

As an example, the projection magnification of projection optical system PL is to be 1/4. Therefore, when reticle R is illuminated by illumination light IL with uniform illuminance as is previously described, a pattern of reticle R within the illumination area is reduced by projection optical system PL, and is projected on wafer W to which a photoresist is applied, and a reduced image of the pattern is formed on a part of an area subject to exposure (a shot area) on wafer W. At this point, projection optical system PL forms the reduced image in a part (that is to say, a rectangular shaped area which is an exposure area, and is conjugate with the illumination area in projection optical system PL) of its field. Incidentally, while the image-forming characteristic correction controller previously described moves at least one optical element (such as a lens element) of projection optical system PL so as to adjust the optical properties of projection optical system PL, or in other words, to adjust the image-forming state of the pattern image on wafer W, alternatively, or in combination with such movement, for example, at least one of changing the optical properties (e.g. center wavelength, spectral wavelength and the like) of illumination light IL by the control of the light source and driving wafer W in the Z-axis direction parallel with optical axis AXp of projection optical system PL (and in a tilt direction with respect to the XY plane) can be performed.

Wafer stage WST is driven by drive system 22 including a linear motor and the like, and is equipped with an XY stage 20 which moves in the XY plane and a wafer table 18 mounted on XY stage 20. On wafer table 18, wafer W is held by vacuum suction or the like by a wafer holder (not shown). Wafer table 18 finely drives the wafer holder holding wafer W in the Z-axis direction and the tilt direction with respect to the XY plane, and is also referred to as a Z tilt stage. On the upper surface of wafer table 18, a movable mirror (or a reflection surface which has been mirror processed) 24 is provided, and on movable mirror 24, a laser beam (a measurement beam) is irradiated from a laser interferometer 26, and positional information in the XY plane and rotational information (including yawing (θz rotation which is rotation around the Z-axis), pitching (θx rotation which is rotation around the X-axis), and rolling (θy rotation which is rotation around the Y-axis)) of wafer table 18 are measured, based on the reflection light from movable mirror 24.

Measurement values of laser interferometer 26 are supplied to main controller 28, and based on the measurement values of laser interferometer 26, main controller 28 controls the position (including the θz rotation) of wafer table 18 in the XY plane by controlling XY stage 20 of wafer stage WST via drive system 22.

Further, the position of the wafer W surface in the Z-axis direction and the amount of inclination are measured by a focus sensor AFS consisting of a multiple point focal position detection system of an oblique incidence method that has a light-transmitting system 50a and a light-receiving system 50b as is disclosed in, for example, U.S. Patent No. 5,448,332 and the like. Measurement values of focus sensor AFS are also supplied to main controller 28.

Further, on wafer table 18, a fiducial plate FP is fixed whose surface is set to be the same height as the height of the surface of wafer W. On the surface of fiducial plate FP, at least a pair of first fiducial marks which is detected along with a pair of reticle alignment marks by a reticle alignment system to be described later on, a second fiducial mark used in the so-called baseline measurement of an alignment system AS which is described below, and the like are formed (the first and second fiducial marks are not shown).

In the embodiment, on a side surface of barrel 40 of projection unit PU, alignment system AS is provided which detects an alignment mark formed on wafer W. As alignment system AS, as an example, an FIA (Field Image Alignment) system is used which is a type of an image-forming alignment sensor by an image processing method that measures a mark position by illuminating a mark using a broadband (a wide band) light such as a halogen lamp and performing image processing of the mark image. The resolution limit of alignment system AS is larger (the resolution is low) than the resolution limit of projection optical system PL.

A detection signal DS of alignment system AS is supplied to an alignment controller 16, and alignment controller 16 performs an AD conversion of detection signal DS, computes the waveform signal that has been digitized, and detects the mark position. The results are supplied to main controller 28 from alignment controller 16.

Furthermore, in exposure apparatus 100 of the embodiment, although it is omitted in the drawings, above reticle R, a pair of reticle alignment detection systems consisting of a TTR (Through The Reticle) alignment system which uses light of an exposure wavelength is arranged as is disclosed in, for example, U.S. Patent No. 5,646,413 and the like, and detection signals of the reticle alignment system are supplied to main controller 28 via alignment controller 16.

Next, an example of a reticle used to measure the optical properties of the projection optical system in exposure apparatus 100 will be described.

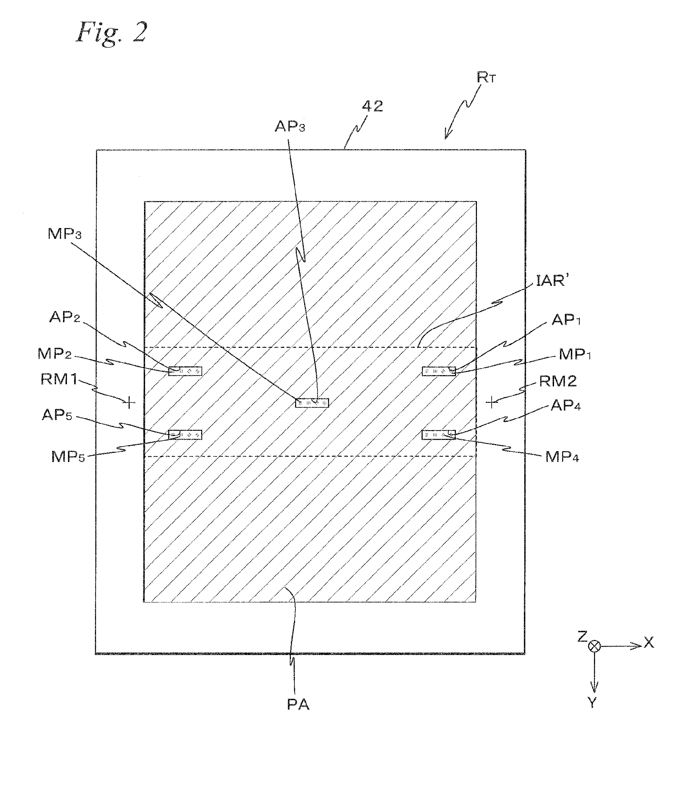

FIG. 2 shows an example of a reticle R_{T} which is used to measure the optical properties of the projection optical system. FIG. 2 is a planar view of reticle R_{T} when viewing from a pattern surface side (the lower surface side in FIG. 1). As shown in FIG. 2, reticle R_{T} consists of a rectangular (to be more precise, a square) glass substrate 42, and on the pattern surface, a substantially rectangular pattern area PA set by a light shielding band (not shown) is formed. In this example (the example in FIG. 2), almost the entire surface of pattern area PA is a light shielding section by a light shielding member such as chrome and the like. At a total of five places, which are the center of pattern area PA (in this case, coincides with the center of reticle R_{T} (reticle center)), and the four corners within a virtual rectangular area IAR' whose center is the reticle center and longitudinal direction is in the X-axis direction, aperture patterns (transmitting areas) AP₁ to AP₅, elongated in the X-axis direction with a predetermined width of, for example, 27µm, and a predetermined length of, for example, 108µm, are formed, and inside aperture patterns AP₁ to AP₅, patterns MP₁ to MP₅ used for measurement are formed, respectively. The size and shape of rectangular area IAR' described above substantially coincide with those of the illumination area previously described. Incidentally, while almost the entire surface of pattern area PA is a light shielding section in this example (the example in FIG. 2), because both ends in the X-axis direction of rectangular area IAR' are set by the light shielding band previously described, it is also possible, for example, to just provide light shielding sections of a predetermined width (for example, the width which is the same as the light shielding band) on both ends in the Y-axis direction.

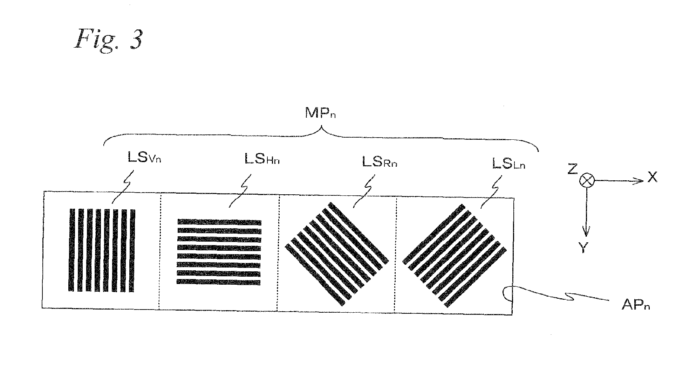

Each of patterns MPₙ (n =1 to 5) which are used for measurement includes four types of line-and-space patterns (hereinafter also described as "L/S patterns") LS_{Vn}, LS_{Hn}, LS_{Rn}, and LS_{Ln} that are shown enlarged in FIG. 3. Each of L/S patterns LS_{Vn}, LS_{Hn}, LS_{Rn}, and LS_{Ln} is configured of a multi-bar pattern which has eight line patterns having a predetermined line width of, for example, 0.8µm, and a predetermined length of around 24µm that are arranged at a predetermined pitch of, for example, 1.6µm, in each of their periodic directions. In this case, the periodic directions of L/S patterns LS_{Vn}, LS_{Hn}, LS_{Rn}, and LS_{Ln} are in the X-axis direction, the Y-axis direction, a direction at an angle of -45 degrees with respect to the Y-axis, and a direction at an angle of +45 degrees with respect to the Y-axis, respectively. Incidentally, each periodic direction corresponds to the measurement direction of each L/S pattern. Further, in the embodiment, the width in a non-measurement direction (the length (24µm) of the individual line pattern) of the L/S pattern is set longer than (in this case, double the length of) the width in the measurement direction (arrangement width (12µm) of the line pattern).

In the embodiment, in four square areas (27µm x 27µm) surrounded by solid lines and dotted lines into which aperture pattern APₙ is divided as shown in FIG. 3, L/S patterns LS_{Vn}, LS_{Hn}, LS_{Rn}, and LS_{Ln} that share the same center as the square areas are placed, respectively. Incidentally, there are actually no borders between the square areas indicated by the dotted lines.

Further, on both sides in the X-axis direction of pattern area PA which passes through the reticle center previously described, a pair of reticle alignment marks RM1 and RM2 are formed (refer to FIG. 2).

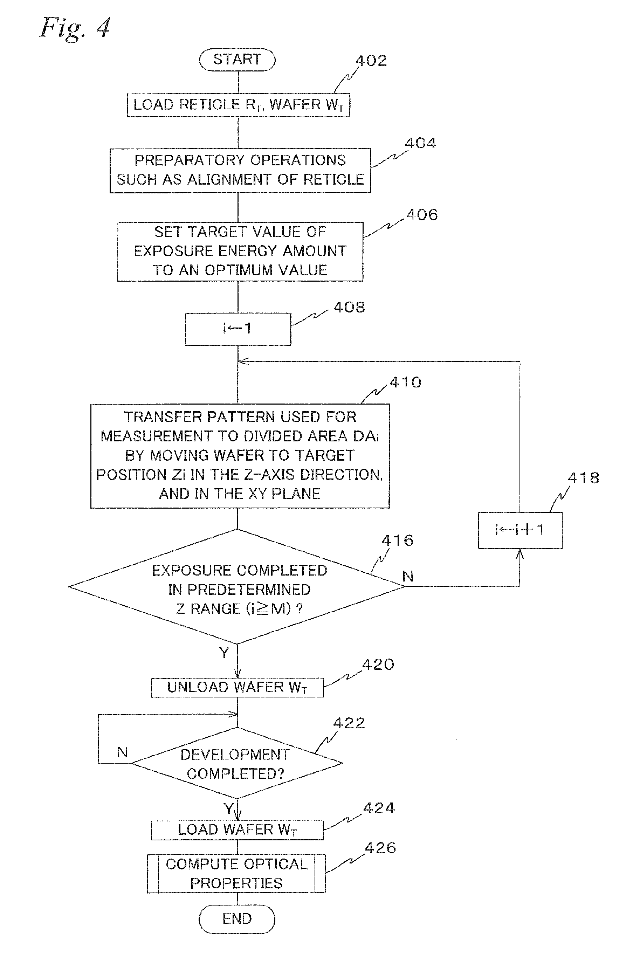

Next, a measurement method of optical properties of projection optical system PL in exposure apparatus 100 of the embodiment will be described, according to a flow chart of FIG. 4 which shows a simplified processing algorithm of the CPU in main controller 28 and also using other drawings appropriately.

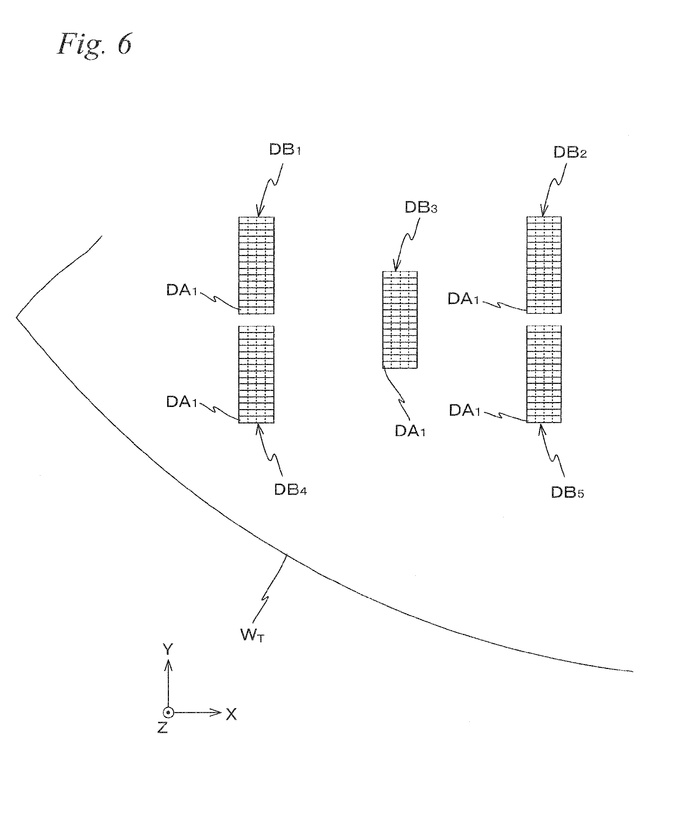

First of all, in step 402 of FIG. 4, reticle R_{T} is loaded on reticle stage RST via a reticle loader (not shown), and a wafer W_{T} (refer to FIG. 6) is also loaded on wafer table 18 via a wafer loader (not shown).

In the following step 404, predetermined preparatory operations such as alignment of reticle R_{T} with respect to projection optical system PL are performed. To be concrete, reticle stage RST and wafer stage WST (XY stage 20) are moved based on measurement values of laser interferometers 14 and 26, respectively, so that the pair of first fiducial marks (not shown) on fiducial plate FP previously described and the pair of reticle alignment marks RM1 and RM2 of reticle R_{T} are detected by the reticle alignment system (not shown) previously described. And, based on detection results of the reticle alignment system previously described, a position (including rotation) of reticle stage RST in the XY plane is adjusted. This sets rectangular area IAR' of reticle R_{T} within the illumination area previously described, and the entire surface will be irradiated with illumination light IL. Further, in the embodiment, a position where a projected image (a pattern image) of pattern MPₙ used for measurement is generated via projection optical system PL within its field (especially the exposure area) becomes an evaluation point within the exposure area of projection optical system PL where optical properties (for example, focus position) of projection optical system PL should be measured. In the embodiment, a total of five evaluation points are set, which are the center and the four corners of the exposure area previously described. Incidentally, while the evaluation points which are actually set may be more, such as, for example, around 9 x 9 = 81 points, in this case, for the sake of convenience of the drawings and the explanation, the evaluation points are the five points described above. However, the evaluation points can be of any number, and one evaluation point is also acceptable.

When the predetermined preparatory operations are completed in the manner described above, the processing moves to the following step 406, in which a target value of an exposure energy amount is set to an optimum value. The optimum value of the exposure energy amount is obtained beforehand by an experiment, simulation, or the like, and as an example, an energy amount which is around 60 to 70% of the energy amount that can resolve a L/S pattern having a minimum line width on the reticle used to manufacture a device is to be the optimum value quantity.

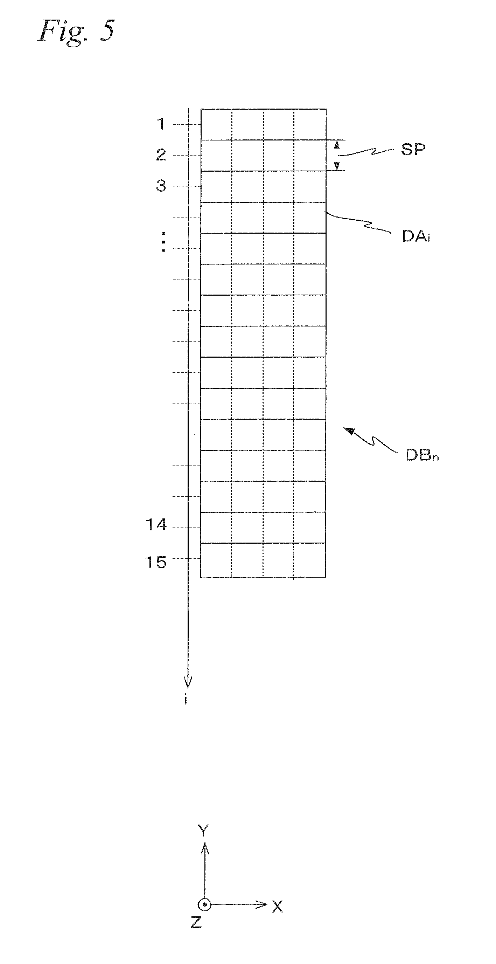

In the following step 408, a count value i of a first counter is initialized (i ← 1). In the embodiment, count value i is also used when setting a divided area DAᵢ which is subject to exposure in step 410 which will be described later on (refer to FIG. 5), along with setting a target value Zᵢ of a focus position of wafer W_{T}. In the embodiment, for example, a focus position of wafer W_{T} is varied from Z₁ to Z_{M} (as an example, M =15) (Zᵢ=Z₁ to Z₁₅) by ΔZ, with a known best focus position (a designed value and the like) related to projection optical system PL serving as a center.

Accordingly, in the embodiment, M times of exposure (in this example, M =15) to sequentially transfer pattern MPₙ (n= 1 to 5) used for measurement on wafer W_{T} will be performed, while varying a position (a focus position) of wafer W_{T} in an optical axis direction (the Z-axis direction) of projection optical system PL. In the embodiment, a projection area on wafer W_{T} of aperture pattern APₙ by projection optical system PL is referred to as a measurement pattern area, and in the measurement pattern area, a projection image of pattern MPₙ used for measurement is generated, and by each exposure, aperture pattern APₙ is transferred on wafer W_{T} and a divided area which includes a transferred image of pattern MPₙ used for measurement is formed. Therefore, at areas (hereinafter referred to as "evaluation point corresponding areas") DB₁ to DB₅ (refer to FIG. 6) on wafer W_{T} corresponding to the respective evaluation points in the exposure area (corresponding to the illumination area previously described) of projection optical system PL, 1 x M patterns MPₙ used for measurement will be transferred.

Now, although the description lacks in sequence, each of evaluation point corresponding areas DBₙ on wafer W_{T} to which pattern MPₙ used for measurement will be transferred by the exposure described later on will be described using FIG. 5, for the sake of convenience. As shown in FIG. 5, in the embodiment, pattern MPₙ used for measurement is transferred onto M x 1 = M (e.g. 15 x 1 = 15) virtual divided areas DAᵢ (i=1 to M (e. g. M =15)) which are placed in a shape of an M row 1 column (e.g. 15 rows 1 column) matrix, respectively, and evaluation point corresponding area DBₙ consisting of M (e.g. 15) divided areas DAᵢ on each of which pattern MPₙ used for measurement is transferred is formed on wafer W_{T}. Incidentally, as shown in FIG. 5, virtual divided areas DAᵢ are arranged so that the -Y direction becomes a row direction (an increasing direction of i). Further, suffixes i and M used in the description below are to have the same meaning as in the description above.

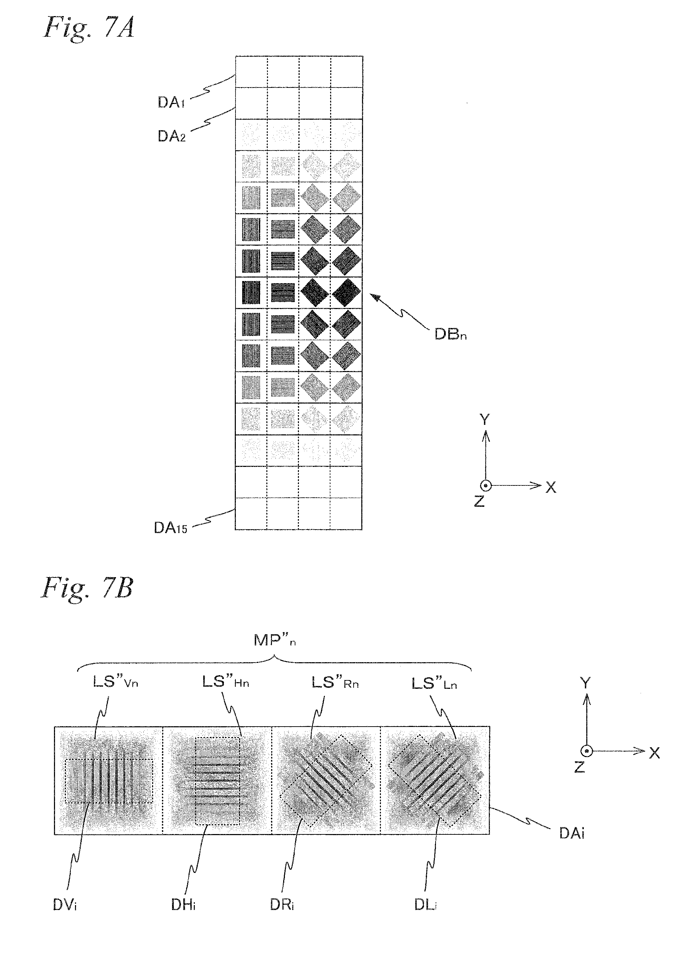

Referring back to FIG. 4, in the following step 410, wafer W_{T} is moved to target position Zᵢ (in this case, Z₁) in the Z-axis direction by driving wafer table 18 in the Z-axis direction (and the tilt direction) while monitoring measurement values from focus sensor AFS, as well as being moved in the XY plane, and virtual divided area DAᵢ (in this case, DA₁ (refer to FIG. 7A)) within each of evaluation point corresponding areas DBₙ (n =1,2, ...... 5) on wafer W_{T} is exposed, and an image of pattern MPₙ used for measurement is transferred onto virtual divided area DAᵢ (in this case, DA₁), respectively. At this point, an exposure amount is to be controlled so that an exposure energy amount (integrated exposure amount) at one point on wafer W_{T} reaches a target value which has been set.

This allows an image of aperture pattern APₙ including pattern MPₙ used for measurement to be transferred onto divided area DA₁ of each of evaluation point corresponding areas DBₙ on wafer W_{T}, as shown in FIG. 6.

Referring back to FIG. 4, when exposure of step 410 described above is completed, the processing moves to step 416, in which the judgment is made of whether or not exposure in a predetermined Z range has been completed, by judging whether or not the target value of the focus position of wafer W_{T} is equal to or exceeds Z_{M} (whether count value i ≥ M). Here, because only exposure at the first target value Z₁ has been completed, the processing moves to step 418, in which count value i is incremented by one (i ← i+1), and then the processing returns to step 410. In step 410, wafer W_{T} is moved to a target position Z₂ in the Z-axis direction by driving wafer table 18 in the Z-axis direction (and the tilt direction), as well as being moved in the XY plane, and virtual divided area DA₂ within each of evaluation point corresponding areas DBₙ (n =1,2, ...... 5) on wafer W_{T} is exposed, and aperture pattern APₙ including pattern MPₙ used for measurement is transferred onto the virtual divided area DA₂, respectively. At this point, prior to starting exposure, XY stage 20 is moved in a predetermined direction (in this case, a +Y direction) within the XY plane by a predetermined step pitch SP (refer to FIG. 5). Now, in the embodiment, step pitch SP described above is set to around 6.75µm which approximately agrees with the size in the Y-axis direction of the projection image of each of the aperture patterns APₙ on wafer W_{T} (corresponding to the measurement pattern area previously described). Incidentally, while step pitch SP is not limited to around 6.75µm, it is desirable that the images of patterns MPₙ used for measurement which are each transferred on adjacent divided areas do not overlap each other and that the step pitch is equal to or less than 6.75µm, i.e., is equal to or less than the size in the Y-axis direction of the projection image of each of the aperture patterns APₙ on wafer W_{T} (corresponding to the measurement pattern area previously described).

In this case, because step pitch SP is equal to or less than the size in the Y-axis direction of the projection image of aperture patterns APₙ on wafer W_{T}, there are no frame lines formed by a part of images of aperture patterns APₙ or areas which are not exposed at a border section between divided area DA₁ and divided area DA₂ of each evaluation point corresponding area DBₙ.

Hereinafter, until the judgment in step 416 is affirmed, or in other words, until the target value of the focus position of wafer W_{T} set then is judged to be Z_{M}, a loop processing (including judgment) of steps 416 → 418 → 410 is repeated. This allows aperture pattern APₙ including pattern MPₙ used for measurement to be transferred onto divided areas DAᵢ (i= 3 to M) of each of the evaluation point corresponding areas DBₙ on wafer W_{T}, respectively. However, also in this case, for the same reasons as is previously described, there are no frame lines or areas which are not exposed at a border section between adjacent divided areas.

On the other hand, when exposure of divided area DA_{M} (DA₁₅ in this example) of each of evaluation point corresponding areas DBₙ has been completed, and the judgment in step 416 described above is affirmed, the processing moves to step 420. At the stage when the judgment in step 416 is affirmed, in each of evaluation point corresponding areas DBₙ on wafer W_{T}, transferred images (latent images) of M (M =15 in the example) patterns MPₙ used for measurement are formed whose exposure condition (in the example, focus position) is different as shown in FIG. 6. Incidentally, while each of evaluation point corresponding areas DBₙ is actually formed when M (M =15 in the example) divided areas, in which the transferred images (latent images) of pattern MPₙ used for measurement are formed, are formed on wafer W_{T} in the manner described above, in the description above, for the sake of simplicity, an explanation method in which evaluation point corresponding areas DBₙ are already existing on wafer W_{T} has been employed.

Referring back to FIG. 4, in step 420, wafer W_{T} is unloaded from wafer table 18 via a wafer unloader (not shown), and wafer W_{T} is carried to a coater developer (not shown) which is in-line connected to exposure apparatus 100 using a wafer carrier system (not shown).

After the carriage of wafer W_{T} to the coater developer described above, the processing proceeds to step 422 and waits for development of wafer W_{T} to be completed. During the waiting time in step 422, development of wafer W_{T} is performed by the coater developer. By the development being completed, on wafer W_{T}, resist images of evaluation point corresponding areas DBₙ (n =1 to 5) as shown in FIG. 6 are formed, and wafer W_{T} on which such resist images are formed becomes a sample which is used to measure the optical properties of projection optical system PL. FIG. 7A shows an example of the resist image of evaluation point corresponding area DB₁ formed on wafer W_{T}.

While FIG 7A shows evaluation point corresponding area DB₁ being configured by M (=15) divided areas DAᵢ (i = 1 to 15) and illustrated as if there is a resist image of a partition frame between adjacent divided areas, this illustration is employed in order to make the individual divided areas easy to understand. However, there are actually no resist images of partition frames between the adjacent divided areas. By eliminating the frames in this manner, a decrease in contrast of a pattern section due to interference caused by the frames can be prevented when taking in the images of evaluation point corresponding areas DBₙ by alignment system AS previously described and the like. Because of this, in the embodiment, step pitch SP previously described is set so as to be equal to or less than the size in the Y-axis of the projection image of each of the aperture patterns APₙ on wafer W_{T}. Incidentally, the border between areas (hereinafter appropriately referred to as "measurement mark areas") in which images LS"_{Vn}, LS"_{Hn}, LS"_{Rn}, and LS"_{Ln} (refer to FIG. 7B) of L/S patterns LS_{Vn}, LS_{Hn}, LS_{Rn}, and LS_{Ln} are formed that are shown by dotted lines in FIG. 7A in each of the divided areas actually does not exist.

In the waiting state in step 422 described above, when it has been confirmed that the development of wafer W_{T} has been completed by a notice from a control system of the coater developer (not shown), the processing moves to step 424, in which instructions are given to a wafer loader (not shown), and after wafer W_{T} is loaded again onto wafer table 18 as in step 402 previously described, the processing moves to a subroutine (hereinafter also referred to as an "optical properties measurement routine") in step 426 where the optical properties of the projection optical system are computed.

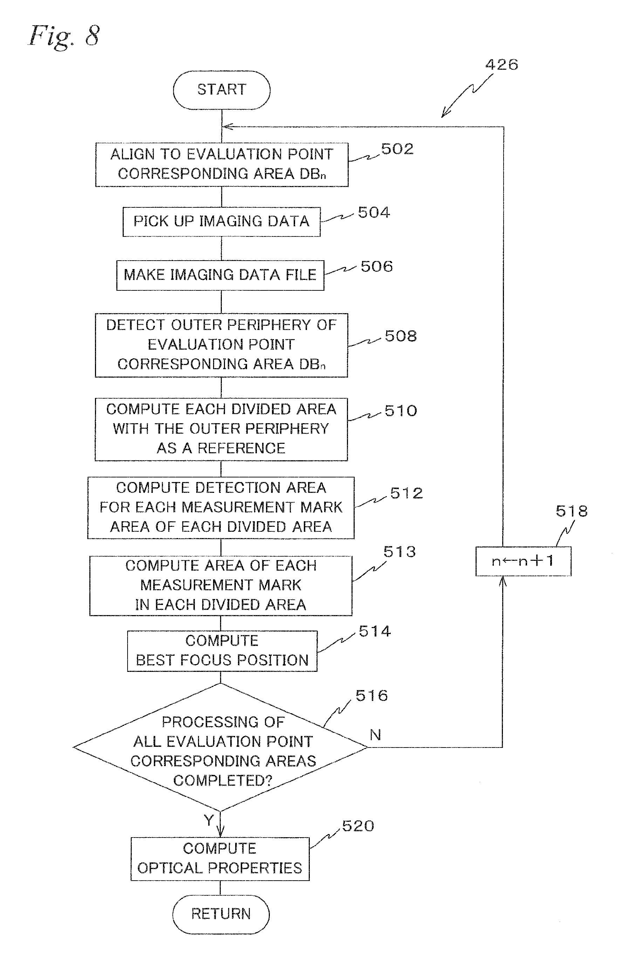

In this optical properties measurement routine, first of all, in step 502 of FIG. 8, wafer W_{T} is moved to a position where a resist image of evaluation point corresponding area DBₙ on wafer W_{T} can be detected by alignment system AS, referring to a count value n of a second counter which shows the number of an evaluation point corresponding area subject to detection. This movement, or in other words, position setting, is performed by controlling XY stage 20 via drive system 22 while monitoring measurement values of laser interferometer 26. Count value n, in this case, is to be initialized to n=1. Accordingly, here, wafer W_{T} is set to a position where the resist image of evaluation point corresponding area DB₁ on wafer W_{T} can be detected by alignment system AS, as shown in FIG. 7A. In the following description on the optical properties measurement routine, the resist image of evaluation point corresponding area DBₙ will be shortly referred to as "evaluation point corresponding area DBₙ" as appropriate.

In the next step 504, a resist image of evaluation point corresponding area DBₙ (in this case, DB₁) on wafer W_{T} is picked up using alignment system AS, and the imaging data are taken in. Alignment system AS splits the resist image into pixel units of an imaging device (CCD and the like) that the system has, and supplies the grayscale of the resist image corresponding to each pixel to main controller 28, for example, as an 8-bit digital data (pixel data). In other words, the imaging data described above are configured of a plurality of pixel data. In this case, when the gray level of the resist image becomes higher (becomes closer to black), the value of pixel data is to increase. Incidentally, because the size of evaluation point corresponding area DBₙ is 101.25µm (the Y-axis direction) x 27µm (the X-axis direction) and the entire area is set in a detection area of alignment system AS in the embodiment, it becomes possible to pick up the images of M divided areas DAᵢ simultaneously (collectively) for each evaluation point corresponding area.

In the next step 506, the imaging data of the resist image formed on evaluation point corresponding area DBₙ (in this case, DB₁) from alignment system AS are arranged, and an imaging data file is made.

In the next step 508, image processing on the imaging data is performed and an outer periphery of evaluation point corresponding area DBₙ (in this case, DB₁) is detected. This outer periphery detection, as an example, can be performed in the following manner.

Specifically, based on the imaging data obtained by the imaging, with a straight line portion configuring an outer frame consisting of an outline of evaluation point corresponding area DBₙ serving as an area subject to detection, by scanning a window area of a predetermined size in a direction which is substantially orthogonal to the straight line portion serving as the area subject to detection, a position of the straight line section subject to detection is detected, based on the pixel data within the window area during the scanning. In this case, because the outer frame section has pixel data whose pixel values (pixel values) are obviously different from the pixel values of other sections, the position of the straight line portion (a part of the outer frame) subject to detection is detected without fail, for example, based on a variation of the pixel data within the window area corresponding to a variation by one pixel each of the position of the window area in the scanning direction. In this case, the scanning direction is preferably in a direction heading from the inner side of the outer frame to the outer side. This is because when a peak of the pixel value corresponding to the pixel data within the window area previously described is obtained at first, the position coincides with the position of the outer frame without fail, which allows a more secure outer frame detection to be performed.

Such a detection of the straight line portion is performed on each of the four sides configuring the outer frame consisting of the outline of evaluation point corresponding area DBₙ. This detection of the outer frame is disclosed in detail, for example, in U.S. Patent Application Publication No. 2004/0179190 and the like.

In the next step 510, by dividing the outer frame of evaluation point corresponding area DBₙ detected above, or in other words, dividing the inside of the frame line of the rectangle into M equal parts (e.g. 15 equal parts) in the Y-axis direction, divided areas DA₁ to DA_{M} (DA₁₅) are obtained. In other words, (positional information of) each divided area is obtained, with the outer frame serving as a reference.

In the next step 512, a detection area is set for each measurement mark area regarding each divided area DAᵢ (i= 1 to M). To be concrete, main controller 28 sets detection areas DVᵢ, DHᵢ, DRᵢ, and DLᵢ (refer to FIG. 7B) with respect to four images LS"_{Vn}, LS"_{Hn}, LS"_{Rn}, and LS"_{Ln} (corresponding to L/S patterns LS_{Vn}, LS_{Hn}, LS_{Rn}, and LS_{Ln} within pattern MPₙ, respectively) which are included in the resist image formed in divided area DAᵢ, respectively.

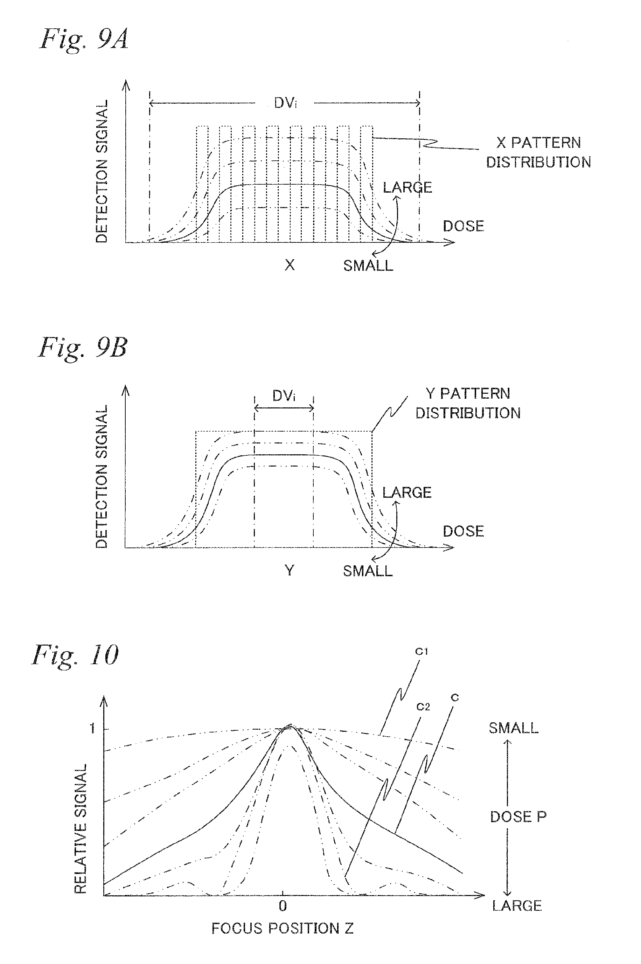

Determination of detection area DVᵢ will be described, with an image (a resist image) LS"_{Vn} of L/S pattern LS_{Vn} formed in divided area DAᵢ serving as an example. L/S pattern LS_{Vn} in pattern MPₙ corresponding to resist image LS"_{Vn} is a multi-bar pattern which has eight line patterns arranged in a measurement direction (the X-axis direction), as shown in FIG. 3. However, under exposure conditions in the actual device manufacturing process, as is obvious from the two-dimensional data shown in FIG. 7B and the one-dimensional data related to the X-axis direction shown in FIG. 9A, the eight line patterns cannot be resolved and detected from image LS"_{Vn} of L/S pattern LS_{Vn} transferred on wafer W_{T}. In the embodiment, main controller 28 obtains an expanse of resist image LS"_{Vn} in the measurement direction, instead of obtaining a contrast value of the image as in the conventional method.

In this case, from the viewpoint of detection sensitivity and the like, it is preferable to obtain the area of resist image LS"_{Vn} as a quantity corresponding to the expanse in the measurement direction. However, as it can be seen from the two-dimensional data shown in FIG. 7B and the one-dimensional data related to the Y-axis direction (non-measurement direction) shown in FIG. 9B, under exposure conditions in the actual device manufacturing process, distribution of the detection signal of resist image LS"_{Vn} becomes gentle with respect to the pattern distribution of L/S pattern LS_{Vn} in the drawing direction (the Y-axis direction), and the expanse varies depending on the exposure conditions (such as the focus position). Accordingly, in the actual exposure conditions, the area of resist image LS"_{Vn} does not correspond to the expanse in the measurement direction.

Therefore, in the embodiment, detection area DVᵢ is set with respect to resist image LS"_{Vn}, as shown in FIG. 7B. In other words, detection area DVᵢ is set sufficiently wider than the distribution of L/S pattern LS_{Vn} in the measurement direction (the X-axis direction) as is shown in FIG. 9A, and is set sufficiently narrower than the distribution of L/S pattern LS_{Vn} in the non-measurement direction (the Y-axis direction) as is shown in FIG. 9B. By this setting, even if the distribution in the non-measurement direction (the Y-axis direction) of resist image LS"_{Vn} varies as a whole according to the exposure conditions, the distribution does not vary within detection area DVᵢ. Accordingly, because the area of resist image LS"_{Vn} within detection area DVᵢ substantially corresponds to the expanse in the measurement direction, the area of resist image LS"_{Vn} within detection area DVi can be employed as a quantity corresponding to the expanse in the measurement direction.

To the other resist images LS"_{Hn}, LS"_{Rn}, and LS"_{Ln} corresponding to L/S patterns LS_{Hn}, LS_{Rn}, and LS_{Ln} in pattern MPₙ as well, detection areas DHᵢ, DRᵢ, and DLᵢ are set as shown in FIG. 7B, according to a similar guideline.

In the following step 513, regarding the four resist images LS"_{Vn}, LS"_{Hn}, LS"_{Rn}, and LS"_{Ln} within each divided area DAᵢ (i = 1 to M), respectively, the area within each of the detection areas DVᵢ, DHᵢ, DRᵢ, and DLᵢ is computed. For example, an area Cₙᵢ of resist images LS"vn, LS"_{Hn}, LS"_{Rn}, and LS"_{Ln} can be obtained by Cₙᵢ = Σₖθ (xₖ-xₜₕ). In this case, xₖ is a detection signal (brightness) of the k^{th} pixel within the detection area, xₜₕ is a threshold value (threshold brightness), and θ(x) is a step function. In other words, area Cₙᵢ is equal to the number of pixels of brightness xₖ that exceeds threshold brightness xₜₕ of the pixels within the detection area. Incidentally, threshold brightness xₜₕ is appropriately decided, according to the required measurement accuracy, the detection sensitivity and the like. Area Cₙᵢ which has been obtained of the resist images is stored for each type (V, H, R, and L) of the four resist images and for each divided area DAᵢ (i) in a storage device (not shown).

In the following step 514, the best focus position for each of the measurement directions at evaluation point corresponding area DBₙ (an n^{th} evaluation point) is obtained, using detection area Cₙᵢ of the four resist images LS"_{Vn}, LS"_{Hn}, LS"_{Rn}, and LS"_{Ln} stored in the storage device (not shown). In this case, for each of the resist images LS"_{Vn}, LS"_{Hn}, LS"_{Rn}, and LS"_{Ln}, main controller 28 plots detection area Cₙᵢ with respect to focus position Zᵢ as shown in FIG. 10. Furthermore, main controller 28 performs a least-squares approximation on plot points using a suitable trial function. FIG. 10 shows an approximate curve (referred to as a focus curve) which has been obtained that is normalized (as a relative signal) using an approximation value at the focus center (Z =0). Incidentally, together in FIG. 10, focus curves which are obtained for different doses (exposure amounts) are shown in two-dot chain lines.

As is obvious from FIG. 10, the shape of the focus curve strongly depends on dose P. For example, to a small dose, the focus curve (for example, curve c₁) shows a gentle curve. Because such a focus curve has low sensitivity to the focus position, it is not suitable when obtaining the best focus position. Further, to a big dose, the focus curve (for example, curve c₂) shows a sharp peak curve. However, satellite peaks appear. Accordingly, such a focus curve is also not suitable when obtaining the best focus position. Compared to these curves, to a moderate dose, the focus curve (for example, curve c) shows an ideal chevron curve. Incidentally, the inventor et al. confirmed by computer simulation that a focus curve of an ideal shape is obtained when the dose amount is 50 to 70% of the dose in the device manufacturing process.

Main controller 28 obtains a best focus position Z_{best} using focus curve c, from its peak center. In this case, the peak center is defined, for example, as a center of two focus positions corresponding to intersecting points of a focus curve and a predetermined slice level.

Main controller 28 performs a computation of the best focus position Z_{best} described above for all of the four resist images LS"_{Vn}, LS"_{Hn}, LS"_{Rn}, and LS"_{Ln}. This allows the best focus position Z_{best} to be obtained for each of the four measurement directions. And, main controller 28 computes an average of the respective best focus positions Z_{best} for the four measurement directions as a best focus position in evaluation point corresponding area DBₙ (the n^{th} evaluation point).

In the following step 516, the judgment is made of whether or not the processing has been completed for all of the evaluation point corresponding areas DB₁ to DB₅, referring to count value n previously described. In this case, because only the processing of evaluation point corresponding area DB₁ has been completed, the decision made in this step 516 is negative, and therefore, after the processing moves to step 518 and count value n is incremented by 1 (n ← n+1), the processing returns to step 502, in which wafer W_{T} is set to a position where evaluation point corresponding area DB₂ can be detected with alignment system AS.

Then, the processing (including judgment) of steps 504 to 514 described above is performed again, and then, the best focus position is obtained for evaluation point corresponding area DB₂, as in the case of evaluation point corresponding area DB₁ described above.

Then, when computing the best focus position for evaluation point corresponding area DB₂ has been completed, in step 516, the judgment is made of whether processing of all of evaluation point corresponding areas DB₁ to DB₅ has been completed or not, and the judgment in this case is negative. Hereinafter, until the judgment in step 516 is affirmed, the processing (including judgment) of steps 502 to 518 described above is repeated. This allows the best focus position to be obtained for each of the other evaluation point corresponding areas DB₃ to DB₅, as in the case of evaluation point corresponding area DB₁ previously described.

When the computation of the best focus position for all of the evaluation point corresponding areas DB₁ to DB₅ on wafer W_{T} is performed, or in other words, computation of the best focus position, at each of the evaluation points previously described that serve as projection positions of the five patterns MP₁ to MP₅ used for measurement within the exposure area of projection optical system PL, is performed, the judgment in step 516 is affirmed. While the optical properties measurement routine can be completed here, in the embodiment, the processing moves to step 520 where other optical properties are computed based on the best focus position data obtained above.

For example, in this step 520, curvature of image plane of projection optical system PL is computed based on the data of the best focus position at evaluation point corresponding areas DB₁ to DB₅, as an example. Further, the depth of focus at each evaluation point in the exposure area previously described can be obtained.

In the embodiment, for the sake of simplicity in the description, while the best focus position at evaluation point corresponding area DBₙ (the n^{th} evaluation point) is obtained based on an average of the respective best focus positions Z_{best} in the four measurement directions at each evaluation point corresponding area (a position corresponding to each evaluation point), as well as this, astigmatism at each evaluation point can be obtained from the best focus positions respectively obtained from a set of L/S patterns whose periodic directions are orthogonal to each other. Furthermore, for each evaluation point within the exposure area of projection optical system PL, based on the astigmatism computed in the manner described above, it is also possible to obtain uniformity within the astigmatism plane, for example, by performing an approximation processing by the least-squares method, as well as to obtain a total focus difference from the uniformity within the astigmatism plane and curvature of image plane.

Then, the optical properties data of projection optical system PL obtained in the manner described above is stored in the storage device (not shown), as well as being shown on a screen of a display device (not shown). This completes the processing of step 520 in FIG. 8, or in other words, completes the processing of step 426 in FIG. 4, which completes the series of measurement processing of the optical properties.

Next, an exposure operation by exposure apparatus 100 of the embodiment in the case of manufacturing a device will be described.

As a premise, information on the best focus position decided in the manner described above, or information on astigmatism (and curvature of image plane) in addition to the information on the best focus position is to be input into main controller 28 via an input-output device (not shown).

For example, in the case where information on the astigmatism (and curvature of image plane) is input, prior to exposure, main controller 28 gives instructions to the image-forming characteristic correction controller (not shown) based on the optical properties data, and corrects the image-forming characteristic of projection optical system PL as much as possible so that the astigmatism (and curvature of image plane) is corrected, for example, by changing a position (including the distance between other optical elements), a tilt or the like of at least one optical element (in the embodiment, a lens element) of projection optical system PL. In this case, the optical element whose position, tilt or the like is changed is not limited to a lens element, and depending on the configuration of the optical system, for example, the optical element can be a catoptric element such as a concave mirror and the like, or an aberration correcting plate which corrects the aberration (such as distortion, spherical aberration and the like) of projection optical system PL, especially correcting the non-rotational symmetrical component. Further, as a correction method of the image-forming characteristic of projection optical system PL, for example, a method of slightly shifting the center wavelength of illumination light IL or a method of changing a refractive index in a part of projection optical system PL can be employed singularly, or by combining the methods with the movement of the optical element.

Then, by main controller 28, reticle R on which a predetermined circuit pattern (device pattern) that is subject to transfer is formed is loaded on reticle stage RST using a reticle loader (not shown), and wafer W is loaded similarly on wafer table 18 using a wafer loader (not shown).

Next, by main controller 28, preparatory operations such as reticle alignment, baseline measurement of alignment system AS and the like are performed in a predetermined procedure using reticle alignment system (not shown), fiducial plate FP on wafer table 18, alignment system AS and the like, and following the operations, wafer alignment is performed, for example, by an EGA (Enhanced Global Alignment) method and the like. In this case, reticle alignment, and baseline measurement of alignment system ALG are disclosed in, for example, U.S. Patent No. 5,646,413 and the like, and the EGA that follows is disclosed in, for example, U.S. Patent No. 4,780,617 and the like. Incidentally, reticle alignment can be performed, using an aerial image measuring instrument (not shown) provided on wafer stage WST, instead of the reticle alignment system.

When the wafer alignment described above is completed, main controller 28 controls each section of exposure apparatus 100, repeatedly performs scanning exposure of the shot areas on wafer W and a stepping operation between shots, and sequentially transfers the pattern of reticle R on all the shot areas subject to exposure on wafer W.

During the scanning exposure described above, based on the positional information in the Z-axis direction of wafer W detected by focus sensor AFS, main controller 28 drives wafer table 18 via drive system 22 in the Z-axis direction and the tilt direction so that the surface of wafer W (shot areas) is set within the depth of focus in the exposure area of projection optical system PL after the optical properties correction previously described, and performs focus leveling control of wafer W. In the embodiment, prior to the exposure operation of wafer W, the image plane of projection optical system PL is computed based on the best focus position at each evaluation point previously described, and based on results of the computation, optical calibration (for example, adjustment of the tilt angle of a plane parallel plate placed in light-receiving system 50b, and the like) of focus sensor AFS is performed. As well as this, for example, a focus operation (and a leveling operation) can be performed, taking into consideration an offset corresponding to a deviation of the image plane computed earlier and a detection reference of focus sensor AFS.

As discussed above, according to the optical properties measurement method related to the embodiment, pattern MPₙ used for measurement formed on reticle R_{T} is transferred sequentially on wafer W_{T} via projection optical system PL, while changing the position of wafer W_{T} used for testing placed on the image plane side of projection optical system PL in the optical axis direction of projection optical system PL, and a plurality of number of divided areas including the image of pattern MPₙ used for measurement is generated on wafer W_{T} used for testing. Then, of the plurality of number of divided areas on wafer W_{T}, a predetermined number of divided areas is imaged, and imaging data of images LS"_{Vn}, LS"_{Hn}, LS"_{Rn}, and LS"_{Ln} (of L/S patterns LS_{Vn}, LS_{Hn}, LS_{Rn}, and LS_{Ln}) of pattern MPₙ used for measurement generated in each of the predetermined number of divided areas whose images are picked up are extracted, and then, as an evaluation amount in the measurement direction related to brightness value of each pixel in each divided area, an amount corresponding to the expanse of images LS"_{Vn}, LS"_{Hn}, LS"_{Rn}, and LS"_{Ln} of each L/S pattern in the corresponding measurement direction is obtained, and the optical properties of projection optical system PL are obtained, based on the amount corresponding to the expanse which has been obtained. This makes it possible to obtain the optical properties of projection optical system PL with good precision.

Further, according to the optical properties measurement method related to the embodiment, to each of images LS"_{Vn}, LS"_{Hn}, LS"_{Rn}, and LS"_{Ln} of pattern MPₙ used for measurement transferred on wafer W_{T} used for testing, at least a part of the image excluding both ends in a corresponding non-measurement direction is detected, and the area of the detected image (at least a part of images LS"_{Vn}, LS"_{Hn}, LS"_{Rn}, and LS"_{Ln}) is obtained as a quantity corresponding to the expanse in the measurement direction. By this, the optical properties of projection optical system PL obtained from the quantity corresponding to the expanse do not have sensitivity to the non-measurement direction; therefore, it becomes possible to precisely obtain the optical properties with respect to the measurement direction. Further, in order to make such treatment easy, the plurality of multi-bar patterns extending in the non-measurement direction arranged in the measurement direction will be used as the pattern used for measurement.

Further, according to the optical properties measurement method related to the embodiment, because the area of a part of images LS"_{Vn}, LS"_{Hn}, LS"_{Rn}, and LS"_{Ln} that has been detected is obtained as an amount corresponding to the expanse in the measurement direction, it becomes possible to perform measurement using a microscope whose resolution is lower than a SEM, e.g., a measurement device such as alignment system AS of exposure apparatus 100. By this arrangement, a severe focusing as in the case of using a SEM becomes unnecessary, which allows the measurement time to be reduced. For example, even in the case where each divided area DAᵢ of each of the evaluation point corresponding areas DBₙ is imaged, unlike the case described above where each of the evaluation point corresponding areas DBₙ is imaged simultaneously, the measurement time per point can be reduced. Further, measurement becomes possible regardless of the type (such as a line and space (an isolated line, a dense line), contact hole, size, and an arrangement direction) of the pattern image, and moreover, regardless of the illumination condition at the time of generation of the projection image (pattern image) of pattern MPₙ used for measurement.

Further, in the embodiment, because quantity corresponding to the expanse in the measurement direction described above is detected, it is not necessary to place a pattern (e.g. a reference pattern for comparison, a mark pattern for positioning and the like) besides pattern MPₙ used for measurement within pattern area PA of reticle R_{T}. Further, the pattern used for measurement can be made smaller in comparison with the conventional method (CD/ focus method, SMP focus measurement method and the like) of measuring dimensions. Therefore, the number of evaluation points can be increased, and the distance between the evaluation points can be narrowed. As a result, measuring accuracy of the optical properties and reproducibility of the measurement result can be improved.

Further, according to exposure apparatus 100, the pattern formed on reticle R is transferred on wafer W via projection optical system PL, after an operation related to adjustment of the image-forming state of the pattern image projected on wafer W via projection optical system PL, such as for example, adjustment of the image-forming characteristic by moving the optical element of projection optical system PL, or calibration of the focus sensor AFS has been performed, so that an optimum transfer can be performed taking into consideration the optical properties of projection optical system PL measured with good precision by the optical properties measurement method previously described.

Therefore, according to the exposure method related to the embodiment, optical properties of projection optical system PL are measured with high precision using the optical properties measurement method described above, and a pattern image is generated with high precision within the exposure area of projection optical system PL taking into consideration the measurement results of the optical properties, and a highly precise exposure (pattern transfer) is realized.

Incidentally, a pattern in which the line having a linewidth of 0.8µm (linewidth 0.2µm is a conversion value on the wafer) configuring each of the L/S patterns of pattern MPₙ used for measurement in the embodiment above is further divided, such as for example, a pattern which is configured of three lines and two spaces which are obtained by further dividing the line into five, can be employed as a pattern used for measurement. In the case of this pattern, the width of each line and each space becomes 40nm on a wafer. It is more preferable when such a pattern is used, because "the change of the area of the pattern previously described" with respect to focus change becomes large, and the best focus position can be detected with high sensitivity. In this case, the line width (or pitch) of a plurality of lines configuring each line pattern of L/S pattern in a conversion value on the wafer is set smaller than the resolution limit of a measurement device (optical system) such as alignment system AS previously described. Incidentally, in the case of fine dense lines including such an L/S pattern and the like which is smaller than the resolution limit, it is desirable to reduce the exposure amount so as to avoid a pattern slant. It is said that pattern slant, here, is easily generated when an aspect ratio which is the ratio of the photoresist film thickness with respect to the pattern dimension is three or more.

Further, in the embodiment above, while the case has been described where four kinds of L/S patterns (multi-bar patterns) placed in aperture pattern APₙ as pattern MPₙ used for measurement on reticle R_{T} are used, the pattern used for measurement is not limited to such a pattern, and the pattern used for measurement can be a pattern including only one pattern or only one kind of patterns, or instead of, or in combination with the L/S pattern, isolation lines and the like can be used.

Further, while the entirety was imaged simultaneously for each evaluation point corresponding area in the embodiment above, for example, it is also possible that one evaluation point corresponding area is divided into a plurality of sections and the sections are each imaged. On this imaging, for example, the imaging can be performed by setting the entire evaluation point corresponding area within the detection area of alignment system AS and then imaging a plurality of sections of the evaluation point corresponding area at a different timing, or the imaging can be performed by setting a plurality of sections of the evaluation point corresponding area sequentially within the detection area of alignment system AS. Furthermore, while the plurality of divided areas configuring one evaluation point corresponding area DBₙ are formed adjacent to each other, for example, a part of the plurality of divided areas (at least one of the divided areas) can be formed separated by a distance equal to or longer than a distance corresponding to the size of the detection area of alignment system AS previously described. Further, while the plurality of divided areas is arranged in a line for every evaluation point corresponding area in the embodiment above, the positions of the plurality of divided areas in a direction (the X-axis direction) orthogonal to the arrangement direction (the Y-axis direction) can be made to be partially different, or for example, in the case such as when the length of the evaluation point corresponding area exceeds the detection area of alignment system AS in the arrangement direction (the Y-axis direction), the divided areas can be placed in a plurality of lines (two-dimensionally) in each of the evaluation point corresponding areas. That is to say, the placement (layout) of the plurality of divided areas can be decided according to the size of the detection area of alignment system AS so that the whole evaluation point corresponding area can be imaged simultaneously for each of the evaluation point corresponding areas. On deciding the placement, it is desirable to decide the step pitch in the X-axis direction so that there are no frame lines or unexposed sections also in the border of adjacent divided areas in the direction (the X-axis direction) orthogonal to the placement direction. Incidentally, while pattern MPₙ used for measurement is transferred onto wafer W_{T} by static exposure in the embodiment, scanning exposure can be employed instead of the static exposure, and in this case, dynamic optical properties can be obtained. Further, exposure apparatus 100 of the embodiment can be of a liquid immersion type, and by transferring the image of pattern MPₙ used for measurement via the projection optical system and liquid, optical properties of the projection optical system including the liquid can be measured.

Incidentally, in the embodiment above, the case has been described where the area (the number of pixels previously described) within the detection area of the image of the measurement mark is detected, and thereby the best focus position and the like of the projection optical system are obtained based on the detection results. However, as well as this, the embodiment described above can be suitably applied to the case where contrast values for every measurement mark area (or each divided area DAᵢ) are detected instead of the area described above, and the best focus position and the like of the projection optical system are obtained based on the detection results, as is disclosed in, for example, U.S. Patent Application Publication No. 2008/0208499 and the like. In this case as well, astigmatism in each evaluation point can be obtained more securely from the best focus position which is obtained by each of a set of L/S patterns whose periodic directions are orthogonal. In this case, as the contrast value for every measurement mark area (or each divided area DAᵢ), dispersion or standard deviation of the brightness value of each pixel of every measurement mark area (or each divided area DAᵢ), or other statistics including deviation with respect to a predetermined reference value of the brightness value of each pixel in each measurement mark area (or each divided area) can be used. Besides this, a statistic of some kind on brightness of each pixel can be employed as contrast information, such as, for example, information on the brightness value of each pixel in each measurement mark area (or each divided area) which does not include the deviation described above, such as, for example, a total sum value or an averaged value of the brightness of each pixel in an area of a predetermined area (predetermined number of pixels) including the pattern image used for measurement, among the measurement mark areas (or divided areas). The point is, when the area (number of pixels and the like) of the imaging area used to compute contrast information in each measurement mark area (or each divided area) is made to be constant, any statistic related to the brightness value of each pixel can be used. Further, for example, in the case of setting an area of the imaging area so that the area includes the pattern image used for measurement and is also set around the same level or smaller than the area of the measurement mark area (or divided area), step pitch SP of wafer W_{T} at the time of transferring the pattern used for measurement can be made larger than the size of the projection image in the Y-axis direction of each aperture pattern APₙ on wafer W_{T} (corresponding to the measurement pattern area previously described).

Further, in the embodiment described above, while the images formed in each of the divided areas on the wafer are all picked up, not all of the images have to be picked up. For example, the divided areas can be imaged alternately.

Incidentally, in the embodiment above, for example, the subject of the imaging can be a latent image formed on the resist on exposure, or an image (etched image) obtained by developing the wafer on which the image above has been formed and further etching the wafer. Further, the photosensitive layer on which an image is formed on an object such as a wafer is not limited to a photoresist, and can be another layer, for example, an optical recording layer, a photomagnetic recording layer and the like, as long as an image (a latent image and a manifest image) is formed by an irradiation of light (energy).

### - Modified Example

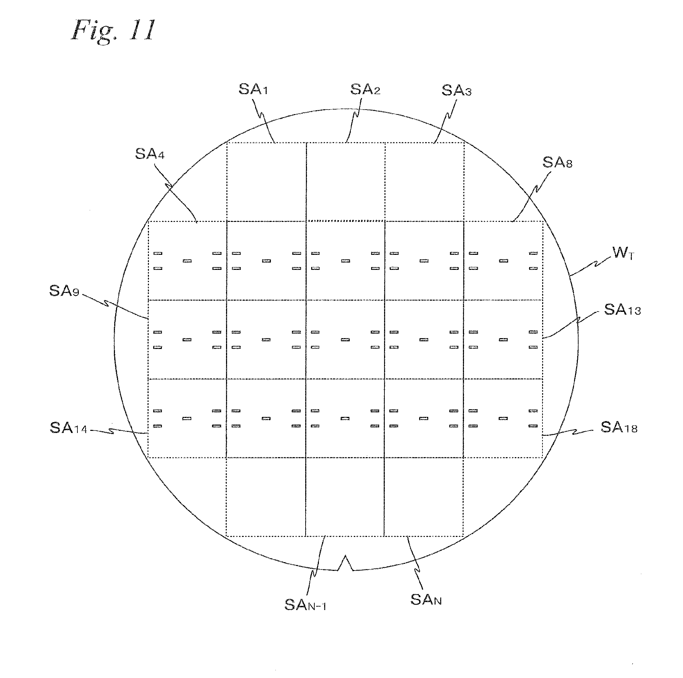

The exposure apparatus of this modified example is configured in the same manner as the exposure apparatus of the embodiment described above. Accordingly, measurement of the optical properties of the projection optical system is basically performed in a procedure similar to the embodiment previously described. However, this modified example is different from the embodiment in that, in step 410 of FIG. 4, step pitch SP employed when wafer W_{T} is moved for scanning exposure of the second divided area DAᵢ and onward is not around 6.75µm, but step pitch SP is to be a stepping distance of when exposure is performed by the step-and-scan method and a device pattern is formed in each of a plurality of shot areas on wafer W, i.e., is to be the size of the shot area in the X-axis direction, for example, around 25mm. Accordingly, on wafer W_{T}, 15 shot areas (resist images), in each of which patterns MP₁ to MP₅ used for measurement are formed, are to be formed like shot areas SA₄ to SA₁₈ shown in FIG. 11. Further, in this case, instead of the processing in steps 502 to 516 previously described, for each of shot areas SA₄ to SA₁₈, imaging data are taken in for the area in which the images of patterns MP₁ to MPₙ used for measurement are formed, imaging data files are made, detection areas are set for every measurement mark area of each area, computation of the area of each measurement mark is performed, and based on results of the computation, computation of the best focus position for each evaluation point is performed.

Since other processing is similar to the embodiment described above, a detailed description will be omitted.

According to the optical properties measurement method related to the modified example described so far, besides being able to obtain an equivalent effect to the effect of the embodiment previously described, it becomes possible to suppress a focus error (an error included in the computation results of the best focus position) depending on a particular position on the wafer, a focus error caused by dust and the like.

Incidentally, in the modified example described above, while the case has been described where the exposure condition changed on transferring the pattern used for measurement is the position (focus position) of wafer W_{T} in the optical direction of projection optical system PL, as well as this, the exposure condition described above can include the exposure amount (dose) and the like, as well as the focus position. In this case, prior to the decision of the best focus position, it is necessary to decide the optimum dose, for example, by selecting a focus curve (for example, curve c) having an ideal chevron shape from a plurality of focus curves for each dose in FIG. 10.

Further, in the modified example described above, while the image of pattern MPₙ used for measurement is transferred onto each divided area by scanning exposure, static exposure can be used instead of scanning exposure, and in this case as well, the step pitch is to be set in a similar manner.

Incidentally, in the embodiment described above, while the image formed in each divided area on the wafer is picked up using the alignment system of the exposure apparatus, an apparatus other than the exposure apparatus, for example, an optical inspection equipment can also be used.

### - Example 1

To confirm the efficiency of the present invention, example 1 related to an aerial image computation (simulation) that the inventor et al. performed will be described here.

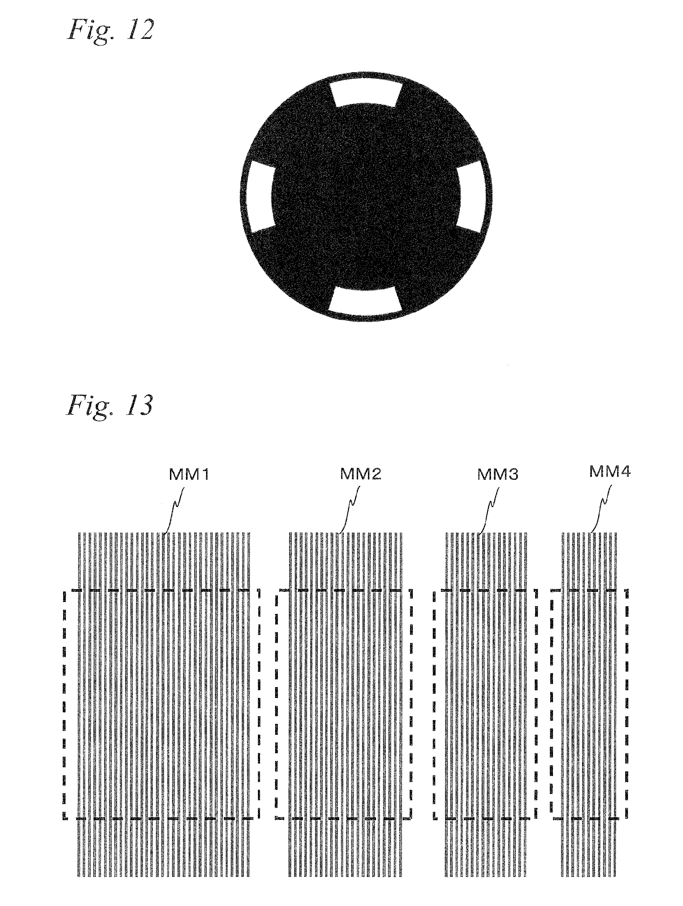

In the example, as the exposure condition serving as a premise, an exposure wavelength of 193nm, projection lens NA =1.30, and a cross-pole illumination condition of azimuth polarization were used. This illumination condition was set with an aperture stop plate whose outer diameter σ =0.95, inner diameter σ =0.75 and has four apertures (angle of view, i.e. central angle of 35 degrees) placed at an angle interval of 90 degrees, as shown in FIG. 12. Further, as the projection optical system (projection lens), a projection optical system that has a lower order astigmatism whose quantity corresponds to 50mλ as a measurement of the fifth term of the Fringe Zernike convention was used.

Under such preconditions, an aerial image intensity distribution of various types of marks used for measurement is obtained changing the focus, and in the case where the image intensity is smaller than the slice level at the time of image shape evaluation, assuming that a resist having a thickness proportional to the image intensity difference remains, a total sum (corresponding to the volume of the residual resist) of the thickness of the residual resist at each point inside the mark area was computed. And, using the computation results, focus dependence of the residual resist volume that accompanies the focus change was obtained, and based on the results, focus positions on both the + and - sides, whose relative values are 0.8 when a value of the residual resist volume that becomes maximum is assumed to be 1, of a focus position corresponding to the maximum value 1 are obtained, and a point corresponding to the midpoint of such focus positions was decided as the best focus position.

Further, under the conditions described above, as a result of obtaining a focus position where contrast of an image of a vertical L/S pattern (ratio of the width of the line section and the space section is 1:1) having a linewidth of 45nm becomes maximum, the focus position was computed to be +10.5nm. Incidentally, the vertical L/S pattern refers to an L/S pattern whose periodic direction is in the X-axis direction.

In the example, in a half tone reticle having a transmissivity of 6%, 4 marks MM1, MM2, MM3, and MM4 were used which are vertical L/S patterns (mark) having a linewidth of 45nm and a length of 6µm in a light-transmitting section, and whose number of lines are 33 (width, 2.925µm), 22 (width, 1.935µm), 16 (width, 1.935µm), and 11 (width, 0.945µm) as shown in FIG. 13, and evaluation of the residual resist volume was performed, limiting the area to a width of 4µm in the center of the mark, which is the range surrounded by broken lines in FIG. 13.

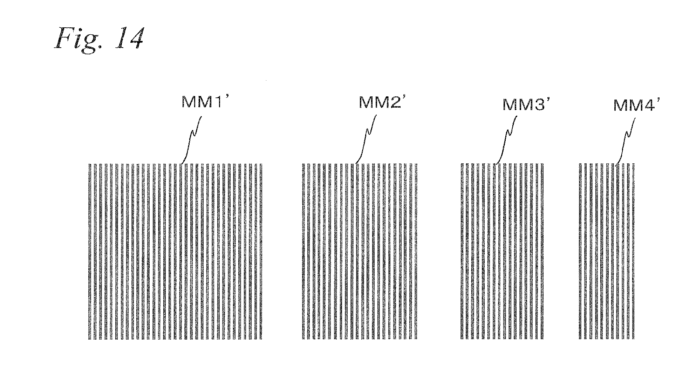

As a comparative example, as shown in FIG. 14, a best focus computation was performed using the conventional two-dimensional measurement, using conventional marks MM1', MM2', MM3' and MM4' which are vertical L/S patterns having a linewidth of 45nm and a length of 3.0µm and whose number of lines are 33, 22, 16 and 11.

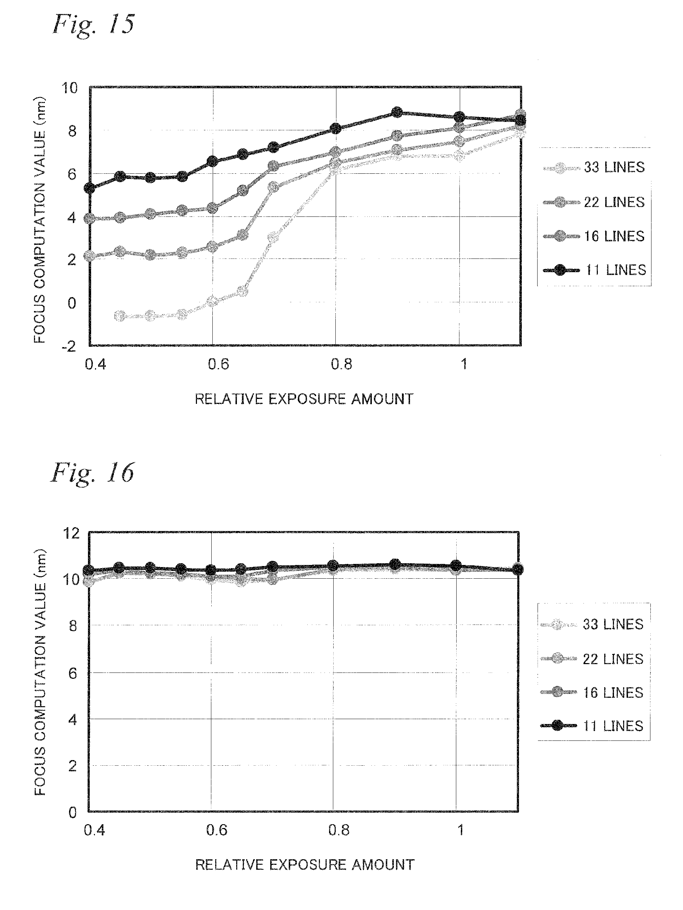

FIG. 15 shows an exposure amount dependence of a best focus computation value in the comparative example. In this case, an exposure amount in which a ratio of the width of the line section and the space section of the L/S pattern with a width of 45nm is resolved to 1:1 was set to 1, and a best focus computation value at a slice level corresponding to relative exposure amounts 0.4 to 1.1 was obtained for each mark. As is obvious from FIG. 15, in the conventional two-dimensional measurement, exposure dependence exists in the best focus measurement value of the vertical lines in the presence of astigmatism, and when the exposure amount is low, divergence from focus position +10.5nm where contrast of the image becomes maximum becomes large. Further, while the exposure dependence decreases when the mark has a fewer number of lines, the best focus position which is measured becomes closer to zero than the focus position where contrast of the image becomes maximum, which shows a lack in sensitivity to astigmatism.

FIG. 16 shows the exposure dependence of the best focus computation value in the example. The definition of exposure amount is the same as in the case of a conventional mark. As it can be seen from FIG. 16, dependence on exposure amount and on the number of marks is extremely small, and the best focus position measured under all conditions substantially coincides with the +10.5nm where the image contrast becomes maximum.

In this manner, according to the example (the optical properties measurement method of the present invention), it becomes possible to perform high-precision measurement of astigmatism amount whose dependence on exposure amount and on the number of marks is extremely small and whose offset (deviation) from the focus position where the contrast of the dense line image becomes maximum is extremely small.

### - Example 2

Next, as example 2, a case will be described when double exposure (trim exposure) is performed to remove information on both ends in the non-measurement direction of a dense line mark (a mark consisting of an L/S pattern).

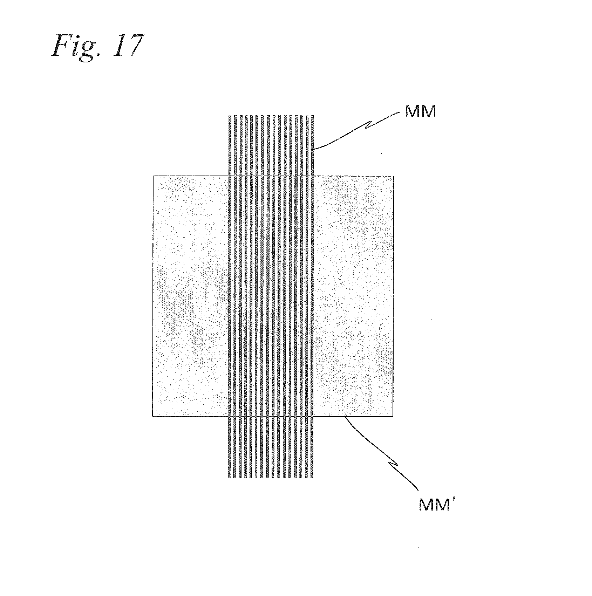

In this example, as shown in FIG. 17, a first mark MM consisting of a vertical L/S pattern which is a halftone pattern with a transmissivity of 6%, with the number of lines being 15, and having a length of 4.2µm and a linewidth of 45nm, and a second mark MM' consisting of a light shielding section having a transmissivity of 0% shaped in a square, 3µm on a side. In this example as well, the exposure conditions are to be the same as example 1 described above, and the astigmatism amount is to exist.

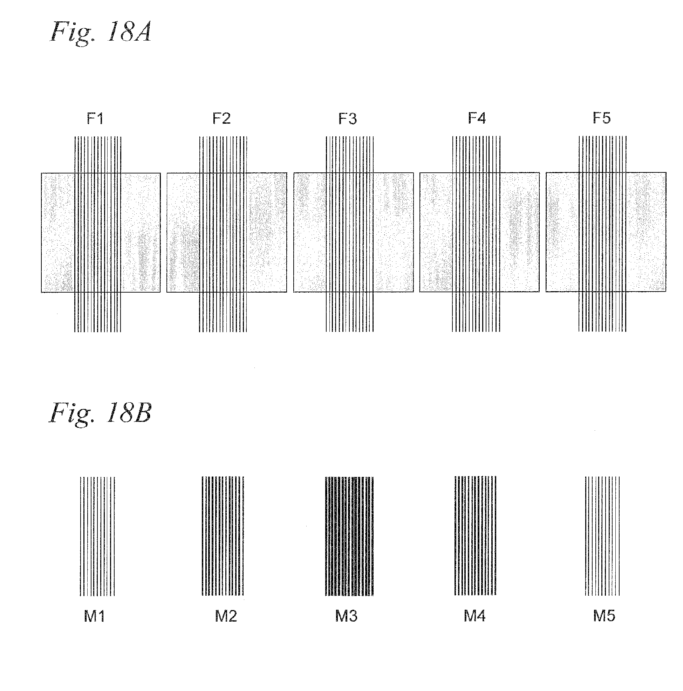

And, as shown in FIG. 18A, at each of focus positions F1 to F5, different areas of the resist layer on the substrate are exposed with the first mark MM, and trim exposure is performed overlaying the second mark MM' on a plurality of areas on the substrate on which an image of the first mark MM has been exposed and transferred. This trim exposure is performed in a state where a positional relation between the first mark MM and the second mark MM' is as shown in FIG. 17, and at a constant focus position F3 (substantially the best focus). Incidentally, the trim exposure can be performed in a state shifted from the best focus position. Further, the ratio of the exposure amount of the trim exposure is to be constant. In this case, as shown in FIG. 17, in the first mark MM, the center becomes the light shielding section, and both of the ends become a light-transmitting section. And, when the substrate is developed after exposure, measurement marks M1 to M5 whose outlines are shown in FIG. 18B that have shapes corresponding to the focus position are formed. Exposure dependence of the best focus computation value is obtained by an aerial image computation for these measurement marks M1 to M5 by the conventional two-dimensional image processing, using the entire two-dimensional mark. Incidentally, the order of exposure using the first mark MM and the second mark MM' can be opposite to the description above.

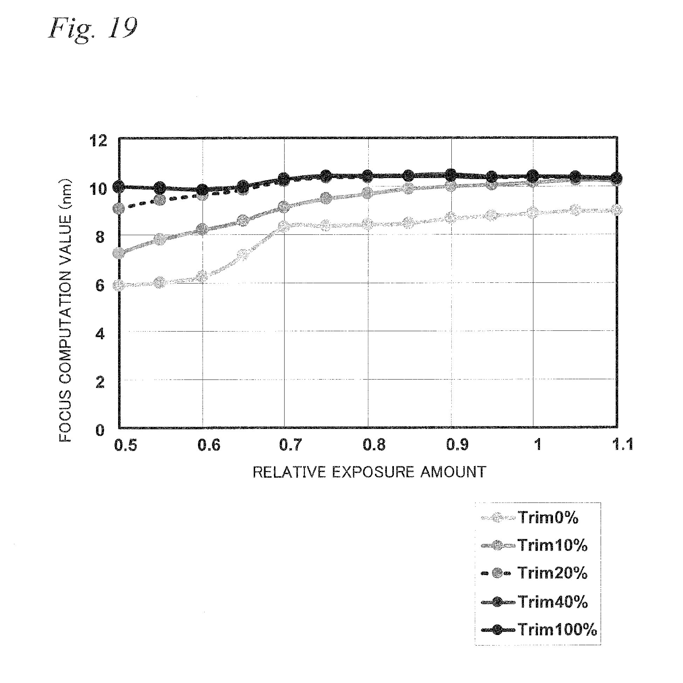

FIG. 19 shows a computation result of this example. From FIG. 19, it can be seen that if the trim exposure amount is 20% or more of the exposure amount of the first mark, measurement of the best focus in which exposure dependence is small and offset with the focus position where the image contrast becomes maximum is small becomes possible. In this case, the number of steps of focus in the case of exposing the first mark is not limited to 5. Further, in the case the shot pitch and the number of shots of the first mark are decided beforehand, the second mark (trim pattern) can be provided on the mask as multiple or a single long rectangular pattern (s) so that the mark(s) can be exposed on all of the first marks in one exposure.

Incidentally, in the embodiment and the modified example described above, while the pattern image on the wafer is detected using a measurement device (alignment system AS, an inspection equipment 2000) of an imaging method, the measurement device is not limited to a device whose light-receiving element (sensor) is an imaging device such as the CCD, and for example, can include a line sensor and the like. In this case, the line sensor can be one-dimensional.

Further, in the embodiment described above, while positional information of wafer stage WST is measured using the interferometer system (26), as well as this, for example, an encoder system can be used which includes a head provided on one of an upper surface of wafer stage WST and outside of wafer stage WST that irradiates a measurement beam on a scale (diffraction grating) provided on the other of the upper surface of wafer stage WST and outside of wafer stage WST and receives a reflected light (diffraction light). In this case, it is desirable that the system is preferably a hybrid system that is equipped with both an interferometer system and an encoder system, and calibration of the measurement results of the encoder system is performed using the measurement results of the interferometer system. Further, by switching and using the interferometer system and the encoder system, or using both of the systems, position control of the wafer stage can be performed.

Further, in the embodiment and the like previously described, while the best focus position, curvature of image plane, and astigmatism are obtained as optical properties of the projection optical system, the optical properties are not limited to these, and other aberrations and the like can also be obtained. Furthermore, the exposure apparatus of the embodiment described above is not limited to the exposure apparatus used for producing semiconductor devices, and can also be an exposure apparatus used for manufacturing other devices such as, for example, a display (such as a liquid crystal display device), an imaging device (such as a CCD), a thin film magnetic head, a micromachine, a DNA chip and the like.

Incidentally, in the embodiment above, while a transmissive type mask, which is a transmissive substrate on which a predetermined light shielding pattern (or a phase pattern or a light attenuation pattern) is formed, is used, instead of this mask, as is disclosed in, for example, U.S. Patent No. 6,778,257, an electron mask (which is also called a variable shaped mask, and includes, for example, a DMD (Digital Micromirror Device) that is a type of a non-emission type image display device (spatial light modulator) or the like) on which a light-transmitting pattern, a reflection pattern, or an emission pattern is formed according to electronic data of the pattern that is to be exposed can also be used. Further, the projection optical system is not limited to a dioptric system, and can also be a catadioptric system or a catoptric system, and is also not limited to a reduction system, and can be an equal magnifying system or a magnifying system. Furthermore, the projection image by the projection optical system can be either an inverted image or an upright image. Further, as is disclosed in, PCT International Publication No. 2001/035168, the embodiment described above can also be applied to an exposure apparatus (a lithography system) which forms a device pattern on wafer W by forming interference fringes on wafer W. Moreover, as is disclosed in, for example, U.S. Patent No. 6,611,316, the embodiment described above can also be applied to an exposure apparatus that synthesizes two reticle patterns via a projection optical system on a wafer, and almost simultaneously performs double exposure of one shot area on the wafer by one scanning exposure. The point is that the embodiment above can be applied as long as the exposure apparatus exposes an object by generating a pattern image used for measurement within the exposure area of the optical system.

Incidentally, in the embodiment described above, the sensitive object (substrate) subject to exposure on which an energy beam (illumination light IL and the like) is irradiated is not limited to a wafer, and may be another object such as a glass plate, a ceramic substrate, a mask blank or the like, and its shape is not limited to a round shape, and can also be a rectangle.

Incidentally, the disclosures of all publications, the PCT International Publications, the U.S. Patent Application Publications and the U.S. Patents that are cited in the description so far related to exposure apparatuses and the like are each incorporated herein by reference.

Semiconductor devices are manufactured going through the steps; a step where the function/performance design of the wafer is performed, a step where a reticle based on the design step is manufactured, a step where a wafer is manufactured using silicon materials, a lithography step where the pattern of the reticle is transferred onto the wafer by executing the exposure method previously described by the exposure apparatus in the embodiment previously described, a device assembly step (including processes such as a dicing process, a bonding process, and a packaging process), an inspection step and the like. In this case, in the lithography step, because the device pattern is formed on the wafer by executing the exposure method previously described using the exposure apparatus in the embodiment previously described, a highly integrated device can be produced with good productivity.

### INDUSTRIAL APPLICABILITY

The optical properties measurement method of the present invention is suitable for measurement of optical properties of an optical system that generates a pattern image on a predetermined plane, such as for example, a projection optical system of a projection exposure apparatus. Further, the exposure method and the device manufacturing method of the present invention are suitable for manufacturing microdevices.

## Claims

1. An optical properties measurement method to measure optical properties of an optical system which generates an image of a pattern placed on a first plane on a second plane, the method comprising:
sequentially transferring a pattern used for measurement whose measurement direction is in a predetermined direction on an object via the optical system while changing a position of the object placed on a side of the second plane of the optical system in an optical axis direction of the optical system, and generating a plurality of divided areas including an image of the pattern used for measurement on the object;
imaging a predetermined number of divided areas of the plurality of divided areas on the object, and extracting, of the image of the pattern used for measurement generated in each of the predetermined number of divided areas that have been imaged, imaging data related to at least a part of an image whose both ends in a non-measurement direction intersecting the measurement direction is excluded; and
computing an evaluation amount in the measurement direction related to a brightness value of each pixel in each of the predetermined number of divided areas using the extracted imaging data, and obtaining the optical properties of the optical system based on the evaluation amount of each of the plurality of divided areas that has been computed.

2. An optical properties measurement method to measure optical properties of an optical system which generates an image of a pattern placed on a first plane on a second plane, the method comprising:
sequentially transferring a pattern used for measurement whose measurement direction is in a predetermined direction on a plurality of areas on an object via the optical system and generating an image of the pattern used for measurement in each of the plurality of areas, while changing a position of the object placed on a side of the second plane of the optical system in an optical axis direction of the optical system;
performing a trim exposure to each of the plurality of areas to remove both ends in the non-measurement direction of the image of the pattern used for measurement that is generated;
imaging a predetermined number of divided areas among a plurality of divided areas on the object each including the image of the pattern used for measurement which has both sides removed in the non-measurement direction; and
processing imaging data obtained by the imaging, and computing an evaluation amount in the measurement direction related to a brightness value of each pixel for each of the predetermined number of divided areas which have been imaged, and also obtaining optical properties of the optical system, based on the evaluation amount of each of the predetermined number of divided areas which has been computed.

3. The optical properties measurement method according to one of Claims 1 and 2 wherein
the pattern used for measurement has a length in the non-measurement direction longer than a width in the measurement direction.

4. The optical properties measurement method according to any one of Claims 1 to 3 wherein
the evaluation amount includes an amount corresponding to an expanse in the measurement direction of the pattern used for measurement.

5. The optical properties measurement method according to Claim 4 wherein
the amount corresponding to the expanse includes an area of the pattern used for measurement.

6. The optical properties measurement method according to any one of Claims 1 to 3 wherein
the evaluation amount includes contrast of the pattern used for measurement.

7. The optical properties measurement method according to any one of Claims 1 to 6 wherein
the pattern used for measurement includes a plurality of patterns arranged in the measurement direction, extending in a non-measurement direction orthogonal to the measurement direction.

8. The optical properties measurement method according to Claim 7 wherein
each of the plurality of patterns consists of a set of a plurality of fine patterns extending in the non-measurement direction that are arranged in the measurement direction.

9. The optical properties measurement method according to any one of Claims 1 to 8 wherein
on generating the image of the pattern used for measurement, a plurality of the images of the pattern used for measurement are generated at different positions within the plurality of areas, under common exposure conditions at least including a position of the object in the optical axis direction.

10. The optical properties measurement method according to any one of Claims 1 to 9 wherein
the optical properties include the best focus position of the optical system.

11. The optical properties measurement method according to Claim 10 wherein
the optical properties further include astigmatism of the optical system.

12. The optical properties measurement method according to any one of Claims 1 to 11, wherein
the pattern used for measurement is transferred onto the object while further changing an exposure dose with respect to the object when generating the image of the pattern used for measurement, and the method further comprising:
obtaining an optimum exposure dose, based on the evaluation amount.

13. An exposure method, comprising:
measuring optical properties of an optical system using the optical properties measurement method according to any one of Claims 1 to 12; and
adjusting at least one of the optical properties of the optical system and a position of the object in an optical axis direction of the optical system and exposing an object by generating a predetermined pattern image on a predetermined plane via the optical system, taking into consideration measurement results of the optical properties.

14. A device manufacturing method, including:
exposing an object by the exposure method according to Claim 13; and
developing the object which has been exposed.
